# EUROPEAN PATENT SPECIFICATION

(11) **EP 1 947 922 B1**
(45) Date of publication and mention of the grant of the patent: **28.11.2012**
(21) Application number: 08100419.4
(22) Date of filing: 14.01.2008
(51) Int. Cl.: H05K 7/20, H05K 5/02, H02B 1/56

(54) **Device for ventilating electrical functional units**
Vorrichtung zur Belüftung elektrischer Funktionseinheiten
Dispositif pour unités électriques fonctionnelles de ventilation

(30) Priority: 19.01.2007 DE 102007002923
(43) Date of publication of application: 23.07.2008
(73) Proprietor: Ormazabal Anlagentechnik GmbH, 47804 Krefeld (DE)
(72) Inventor: Glasmacher, Peter, 41352, Korschenbroich (DE)
(74) Representative: Cohausz & Florack

(56) References cited:
- EP-A1- 1 450 458
- WO-A1-2004/023856
- DE-A1- 3 543 486
- US-A1- 2005 061 485

## Description

The present invention relates to a device for ventilating an electrical functional unit of high and moderate voltage, and to the electrical functional unit.

### PRIOR ART

In normal operation of electrical functional units of moderate and high voltage, such as switchgears, waste heat generated by the electrical functional unit is dissipated outward via a metal grating, in case of an internal fault of the electrical functional unit, such as an electrical arc occurring in a moderate voltage facility, the compressed air generated by the electric arc being exhausted via the same metal grating and a pressure relief flap opened in parallel.

Because of the ever more compact constructions of switchgears, electrical functional units of moderate and high voltage are often used in areas in which it is possible for individuals to travel through the pressure relief areas and the area of the exit opening of the metal grating used for heat dissipation.

An assembly including on electrical functional unit and a device for ventilating the electrical functional unit according to the preamble of claim 1 is kwown from the document EP 1450458.

However, such a configuration displays the disadvantage that in the event of a pressure increase generated by a malfunction such as an electric arc within the electrical functional unit, for example, a part of the hot gas having the high pressure also escapes outward via the metal grating, and endangers the individuals located there.

### DESCRIPTION OF THE INVENTION

Proceeding therefrom, the present invention is based on the object of providing ventilation for an electrical functional unit of moderate and high voltage which offers high protection against hot gases exiting from the electrical functional unit at high pressure.

This object is achieved by an assembly of claim 1.

For example, waste heat from the electrical functional unit, which is generated, for example, by at least one electrical element, such as power switches and/or current/voltage converters and/or bus bars and/or other moderate and/or high voltage electrical components within the electrical functional unit, may be dissipated through the at least one exit opening of the at least one electrical functional unit through the connected at least one outflow path to the environment outside the functional unit, the at least one outflow path being implemented in such a way that it causes cooling and/or pressure reduction of exiting hot gases, so that cooled and/or pressure-reduced gas may be discharged through at least one outlet opening of the at least one outflow path.

The electrical functional unit may be closed except for the at least one outlet opening, so that, for example, hot gases must be exhausted through the at least one outflow path. The electrical functional unit may also, for example, have further closable openings, however, which are open in normal operation and dissipate waste heat to the environment, these closable openings being closed in the event of a high pressure increase, however, for example, using a flap, so that in the event of a malfunction no hot gases may escape through these further closable openings.

Because at least one of the at least one outflow paths is connectable to at least one outlet opening located in the upper area of the electrical functional unit for receiving exiting gases, for example, waste heat may be discharged by natural heat convection from the electrical functional unit through at least one outflow path. Thus, for example, a heat buildup during normal operation of the electrical functional unit, i.e., when there is no malfunction, may be avoided.

The at least one outflow path may be implemented, for example, from a heat-conductive material, such as sheet metal, so that a hot gas conducted through the at least one outflow path may be discharged via the at least one outflow path to the environment outside the electrical functional unit in a controlled way, i.e., with reduced pressure and/or cooled, without endangering individuals at the same time, however. Other suitable materials may also be used for the at least one outflow path. Thus, for example, a great heat suddenly arising inside the electrical functional unit may be dissipated partially in a controlled way to the environment slowly via the surface of the at least one outflow path, while another part of the heat, for example, may be discharged via the at least one outlet opening of the at least one outflow path, for example.

Furthermore, the cooling effect and/or pressure reduction caused by the at least one outflow path may be adjusted by parameters such as length and/or cross-section of the at least one outflow path and thus tailored to the conditions of the electrical functional unit. Thus, for example, the at least one outflow path may have a minimum length, such as the length of a lateral face of the electrical functional unit, so that sufficient cooling and/or damping of exiting gases may be ensured.

Thus, the device according to the present invention displays the advantage that hot gas exiting from the at least one outlet opening of the electrical functional unit which is generated, for example, in the event of a malfunction in the electrical functional unit such as an electric arc, is not discharged directly through the at least one opening of the electrical functional unit to the environment, but rather is initially conducted through the at least one outflow path situated outside the electrical functional unit, the hot gas being cooled and/or reduced in pressure by this at least one outflow path and only then being discharged to the environment to the at least one outlet opening of the at least one outflow path. Therefore, endangerment of individuals outside the electrical functional unit may be prevented in the event of a malfunction in the electrical functional unit.

Since at least one of the at least one outflow paths is guided downward along a back side of the electrical unit, at least one outlet opening of the at least one outflow path may be placed on the back side of the electrical functional unit, in a lower area there, for example, so that high individual safety may be achieved in particular on the front side of the electrical functional unit.

Therefore, hot gases exiting from the electrical functional unit may not only be reduced in pressure and/or cooled, but rather additionally conducted away on the back side of the electrical functional unit, so that endangerment of individuals located in front of the electrical functional unit in particular may be avoided.

The device for ventilating the electrical functional unit may be installed fixed directly on the electrical functional unit, for example, or may represent a component which is mountable, i.e., attachable, and dismountable on the electrical functional unit. For example, the device may be attachable to the electrical functional unit using fasteners, such as screws.

In one design of the present invention, at least one of the at least one outflow paths is guided at least partially long at least one exterior side of the electrical functional unit.

Therefore, the at least one outflow path may be implemented at least partially on at least one exterior side of the electrical functional unit, for example, by which a space-saving attachment of the device may be achieved. For example, the at least one outflow path may run on the top side of the electrical functional unit toward the back side of the electrical functional unit.

In one design of the present invention, at least one of the at least one outflow paths has at least one curvature.

This curvature of the at least one outflow path may be a soft curvature or may also represent a sharp bend, for example.

Therefore, for example, the at least one outflow path on the top side of the electrical functional unit may be connected to at least one exit opening of the electrical functional unit, the at least one outflow path being able to run on the top side of the electrical functional unit, then having a bend and/or a curvature, and running further downward on the back side of the electrical functional unit, so that, for example, the at least one outlet opening of the at least one outflow path may be located in a lower area of the back side of the electrical functional unit.

Therefore, hot gas exiting from the at least one opening of the electrical functional unit, which is generated, for example, in the event of a malfunction in the electrical functional unit such as an electric arc, for example, may be conducted through the exemplary at least one outflow path initially running on the top side of the electrical functional unit, cooled and/or reduced in pressure, then redirected via the curvature of the at least one outflow path and guided through the further outflow path running downward on the back side behind the electrical functional unit, for example, into a lower area of the back side of the electrical functional unit, the hot gases being able to be cooled and/or reduced in pressure further at this time. A longer outflow path may thus be achieved using the at least one curvature of the at least one outflow path, by which a longer path may be achieved for the hot gases upon exiting the electrical functional unit, accompanied by better cooling and/or pressure reduction, by which an improvement of the personal protection in front of the electrical functional unit may be achieved, in particular if a room height of a room in which the electrical functional unit having the device according to the present invention is used is lower than normal, i.e., < 2300 mm, for example. Endangerment of individuals outside the electrical functional unit may thus be prevented in the event of a malfunction in the electrical functional unit.

For example, at least one of the at least one outflow paths may also have multiple curvatures and run on the top and/or back sides of the electrical functional units, by which the length of the at least one outflow path may be lengthened further and greater pressure reduction and/or cooling of the exiting gases may thus also be achieved.

In one design of the present invention, at least one of the at least one outflow paths comprises a module for receiving at least one absorber element to absorb or damp hot gases.

This module for receiving at least one absorber element may be located, for example, in an area of the at least one outflow path on the top side of the electrical functional unit, but also in an area of the at least one outflow path on the back side of the electrical functional unit, or at another suitable point in at least one of the at least one outflow paths. Thus, for example, the at least one module for receiving at least one absorber element may be located at any position inside at least one of the at least one outflow paths, for example, it may also be placed directly in front of at least one of the at least one outflow paths or behind the at least one outlet opening of at least one of the at least one outflow paths.

Together with the at least one absorber element used, this module for receiving at least one absorber element may also achieve further cooling and/or pressure reduction of hot gases conducted through at least one of the at least one outflow paths, by which increased individual safety may be achieved in case of malfunction, for example.

In one design of the present invention, the at least one absorber element is at least one ceramic monolith having channels for the passage of gases.

The at least one absorber element may, for example, be at least one monolithic ceramic body, which has channels for the passage of hot gases and withdraws heat and has a pressure-reducing effect on introduced gas, so that gas guided through this at least one absorber element may be cooled and have its pressure reduced further in addition to the cooling effect and/or pressure reduction caused by the at least one outflow path. For example, this module for receiving at least one absorber element may represent the module disclosed in German Patent Specification DE 103 13 723 B3, and the at least one absorber element disclosed in this patent specification may be used, however, any other suitable module for receiving at least one absorber element for damping and absorbing hot gases may also be used.

In one design of the present invention, at least one of the at least one outflow paths has at least one additional opening closable using a closure element, the closure element closing the additional opening if a predetermined pressure-dependent threshold is exceeded.

The closure element may be open in normal operation of the electrical functional unit, for example, i.e., when no malfunction which generates hot gas exists, so that waste heat generated during normal operation in the electrical functional unit may be discharged directly to the environment by the heated air through the exit opening of the electrical functional unit and the at least one open additional opening, by which a heat buildup may be avoided, for example.

If the pressure in the electrical functional unit rises above a predetermined threshold, for example, in the event of a malfunction in the electrical functional unit, for example, which may be an electric arc at a power switch, for example, the at least one additional opening is closed by the particular closure element, and the hot gases are conducted along the at least one outflow path to the at least one outlet opening of the at least one outflow path to the environment and reduced in pressure and/or cooled, so that endangerment of individuals may be prevented. At least one module for receiving an absorber element may also optionally be located in at least one of the at least one outflow paths.

In one design of the present invention, the closure element represents a flap mounted so it is pivotable.

The pivotably mounted flap may be located on a top side of the at least one outflow path, for example, which may run along the top side of the electrical functional unit, for example, and the at least one flap may be situated hanging on the bottom side of the at least one additional opening, so that in the event of high pressure in the at least one outflow path, which is generated, for example, by exiting hot gases in the event of a malfunction in the electrical functional unit, for example, i.e., if a predetermined pressure-dependent threshold is exceeded, the at least one flap closes automatically and thus seals the at least one additional opening.

However, the at least one closure element may also be implemented by other alternative embodiments, such as a valve, a configuration similar to a valve, or the like.

In one design of the present invention, the device represents a module attachable to the electrical functional unit.

The device may be attachable, i.e., mountable on the electrical functional unit using fasteners, such as a screw connection or snap connection or the like. For example, the device may thus be used for retrofitting electrical functional units. Furthermore, advantages may result in the construction of electrical functional units, because the device according to the present invention may thus be transported separately from the electrical functional unit.

In one design of the present invention, the attachable module forms at least one of the at least one outflow paths together with at least one exterior wall of the electrical functional unit.

Therefore, for example, at least a part of at least one exterior wall of the electrical functional unit may also be used to implement at least one of the at least one outflow paths, so that the at least one of the at least one outflow paths is first implemented when the device is attached to the electrical functional unit. For example, the top side of the electrical functional unit may also be used implement at least one outflow path and/or the back side of the electrical functional unit.

For example, lateral faces of the electrical functional unit may also be used.

For example, the attachable module may have an oblong U-profile for at least one outflow path to be implemented, the open side of the oblong U-profile being closed by a side wall of the electrical functional unit in the attached state of the device and thus an outflow path being implemented. By the additional use of at least one side wall to implement at least one outflow path, material costs may be reduced, for example, and a weight advantage may be achieved for the device, for example

In one design of the present invention, the attachable module is L-shaped and forms at least one of the at least one outflow paths with at least a part of the back side and at least a part of the top side of the electrical functional unit in the attached state, the gases exiting from the electrical functional unit through at least one opening on the top side of the electrical functional unit being guided in the at least one of the at least one outflow paths and conducted to the back side of the electrical functional unit.

In one design of the present invention, the electrical functional unit represents a switchgear for moderate voltage and/or high voltage.

The switchgear may be traversable, for example, and may comprise one or more switch rooms, a separate outflow path through the device being able to be implemented for each of the switch rooms, for example.

In one design of the present invention, the switchgear is air-insulated.

In one design of the present invention, the switchgear is gas-insulated.

The switchgear may be gas-insulated by SF6, for example, however, other suitable gases may also be used for the insulation.

In one design of the present invention, the switchgear is solid-insulated.

In one design of the present invention, the switchgear is insulated by a liquid.

In one design of the present invention, the electrical functional unit represents a transformer unit.

The transformer unit comprises at least one transformer, however, it may also comprise still further electrical elements such as at least one switching device, for example.

The transformer unit may represent a transformer station, for example, furthermore, the transformer unit may also comprise a switchgear.

The electrical functional unit may also represent a combination of a switchgear and a transformer unit.

The device according to present invention has the further advantage that it may be used for retrofitting electrical functional units.

### BRIEF DESCRIPTION OF THE FIGURES

The present invention is explained in greater detail in the following on the basis of drawings which show exemplary embodiments.
- Figure 1:: shows a schematic illustration of a first embodiment of the present invention;
- Figure 2:: shows a schematic illustration of a second embodiment of the present invention;
- Figure 3:: shows a schematic illustration of a third embodiment of the present invention;
- Figure 4:: shows a schematic illustration of a fourth embodiment of the present invention;
- Figure 5a:: shows the side view of a schematic illustration of the fifth embodiment of the present invention;
- Figure 5b:: shows the diagonal view of a schematic illustration of a fifth embodiment of the present invention;
- Figure 5c:: shows the schematic illustration of a fifth embodiment of the present invention in the attached state.

All explanations and advantages cited in the description, for example, of the various designs of the present invention, also apply for the embodiments shown in the figures.

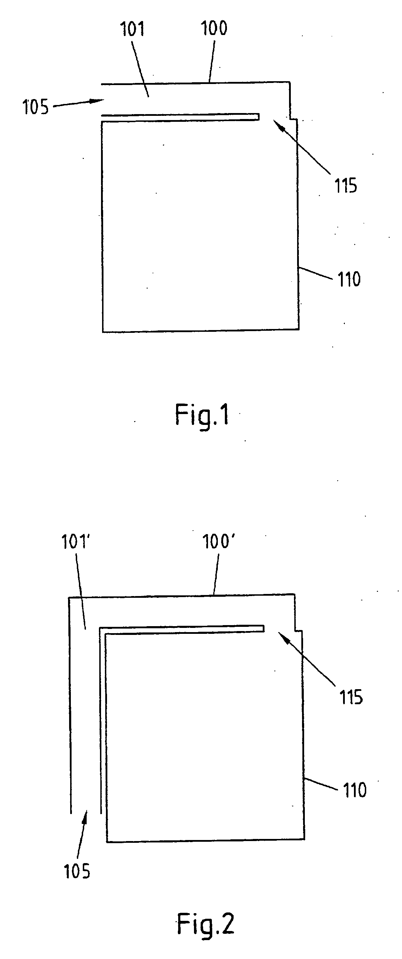

Figure 1 shows a first embodiment of the device 100 for ventilating an electrical functional unit 110 in a schematic illustration.

In all figures, similar elements are provided with identical reference numerals, therefore, statements such as designs or advantages about elements in one embodiment also apply equally for similar elements in the other embodiments.

The electrical functional unit 110 may be a switchgear of moderate and/or high voltage, for example, or a transformer unit, or represent another facility of moderate and/or high voltage, the functional unit being able to be traversable or non-traversable.

The embodiment of the device 100 shown in Figure 1 only shows one outflow path 101 as an example, which is implemented outside the electrical functional unit 110 and has a pressure-reducing and/or cooling effect on the gases exiting from the electrical functional unit 110. However, the device 100 may also implement still further outflow paths for reducing the pressure and/or cooling gases exiting from the electrical functional unit 110.

The at least one outflow path 101 may be connected to at least one exit opening 115 of the electrical functional unit 110. This at least one exit opening 115 may be located on the top side of the electrical functional unit 110, for example, as shown in Figure 1, or may also be located in another area of one of the side walls of the electrical functional unit 110.

For example, waste heat from the electrical functional unit 110, which is generated, for example, by at least one electrical element such as power switches and/or current/voltage converters and/or bus bars and/or other moderate and/or high voltage electrical components inside the electrical functional unit 110, may be dissipated through the at least one exit opening 115 of the electrical functional unit 110 through the connected at least one outflow path 101 to the environment outside the functional unit 110. The at least one outflow path 101 is implemented in such a way that it causes cooling and/or pressure reduction of exiting hot gases, so that gas which is cooled and/or has its pressure reduced is discharged through the at least one outlet opening 105 of the at least one outflow path 101.

The at least one outflow path 101 may be implemented for this purpose from a heat conductive material, such as sheet metal, for example, so that a hot gas conducted through the at least one outflow path 101 may be discharged via the at least one outflow path 101 to the environment outside the electrical functional unit 110 in a controlled way, i.e., at a reduced pressure and/or cooled, without endangering individuals, a pressure reduction being able to be influenced by the selection of the cross-section of the heat-conductive material and/or the length and/or the shape of the at least one outflow path, for example. Other suitable materials may also be used for the at least one outflow path 101. Therefore, a great heat suddenly arising inside the electrical functional unit may partially be dissipated slowly via the surface of the at least one outflow path 101 in a controlled way to the environment.

Furthermore, the cooling effect and/or pressure reduction caused by the at least one outflow path 101 may be adjusted by parameters such as length and/or cross-section of the at least one outflow path and thus tailored to the conditions of the electrical functional unit 110. Thus, the at least one outflow path 101 may have a minimum length, such as the length of a lateral face of the electrical functional unit 110, so that sufficient cooling and/or damping of exiting gases may be ensured.

The device according to the present invention thus displays the advantage that hot gas exiting from the at least one opening 115 of the electrical functional unit 110 which is generated, for example, in the event of a malfunction in the electrical functional unit 110 such as an electric arc is not discharged directly through the at least one opening 115 of the electrical functional unit 110 to the environment, but rather is first conducted through the at least one outflow path 101 situated outside the electrical functional unit, the hot gas being cooled and/or reduced in pressure by this at least one outflow path 101, and only then being discharged to the environment through the at least one outlet opening 105. Therefore, endangerment of individuals outside the electrical functional unit 110 in the event of a malfunction in the electrical functional unit 110 may be prevented.

Because at least one of the at least one outflow paths is connectable to at least one exit opening for receiving exiting gases located in an upper area of the electrical functional unit, waste heat may also be discharged through at least one outflow path from the electrical functional unit by natural heat convection, for example. Thus, for example, a heat buildup during normal operation of the electrical functional unit, i.e., when no malfunction exists, may be avoided.

For example, the at least one outflow path 101 may be implemented in such a way that the at least one outlet 105 of the at least one outflow path 101 is located on the back side of the electrical functional unit 110. Therefore, hot gases exiting from the electrical functional unit 110 may not only be reduced in pressure and/or cooled, but rather additionally conducted away to the back side of the electrical functional unit 110, so that endangerment of individuals located in front of the electrical functional unit 110 in particular may be avoided.

The device 100 for ventilating the electrical functional unit 110 may, for example, be installed fixed directly on the electrical functional unit 110, or may represent a component 100 which is mountable, i.e., attachable, and dismountable to and from the electrical functional unit 110. For example, the device 100 may be attachable to the electrical functional unit 110 using fasteners, such as screws.

Figure 2 shows a second embodiment of the device 100' for ventilating an electrical functional unit 110 in a schematic illustration.

The explanations and advantages just cited in regard to the first embodiment apply equally for the second embodiment shown in Figure 2.

In relation to the device 100 illustrated in Figure 1, the device 100' illustrated in Figure 2 has the difference that the at least one outflow path 101' has at least one curvature. This curvature may be a soft curvature, i.e., a curvature having a large radius of curvature, or may also represent a sharp bend, as shown in Figure 2. Therefore, the at least one outflow path 101' may be connected to the at least one exit opening 115 on the top side of the electrical functional unit 110, for example, the at least one outflow path 101' running on the top side of the electrical functional unit 110, then having a bend and/or a curvature, and running downward on the back side of the electrical functional unit 110, so that, for example, the at least one outlet 105 of the at least one outflow path 101' may be located in a lower area of the back side of the electrical functional unit 110, as shown as an example in Figure 2.

Therefore, hot gas exiting from the at least one opening 115 of the electrical functional unit 110, which is generated, for example, in the event of a malfunction in the electrical functional unit 110, such as an electric arc, may be conducted through the at least one outflow path 101' initially running on the top side of the electrical functional unit 110, cooled and/or reduced in pressure here, then redirected via the curvature of the at least one outflow path 101' and guided through the outflow path 101' running further on the back side downward behind the electrical functional unit 110 into a lower area of the back side of the electrical functional unit 110, for example, the hot gases being able to be cooled and/or reduced in pressure further here. Therefore, a significantly longer path results for the hot gases upon exit from the electrical functional unit 110, by which an improvement of the personal protection in front of the electrical functional unit may be achieved, in particular if a room height of a room in which the electrical functional unit having the device 100, 100' according to the present invention is used is lower than normal, i.e., < 2300 mm. Therefore, endangerment of individuals outside the electrical functional unit may be prevented in the event of a malfunction in the electrical functional unit 110.

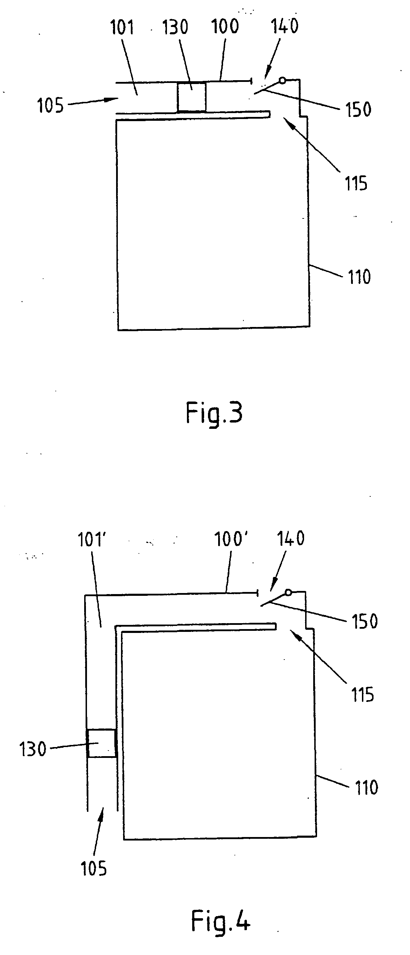

Furthermore, at least one of the at least one outflow paths 101, 101' may comprise at least one module 130 for receiving at least one absorber element for absorbing or damping hot gases, as shown as an example in the third and/or fourth embodiment in Figures 3 and 4. This module 130 for receiving at least one absorber element may be located, for example, in an area of the at least one outflow path 101 on the top side of the electrical functional unit 110, as shown in Figure 3, for example, or may also be located in an area of the at least one outflow path 101' on the back side of the electrical functional unit 110, as shown in Figure 4, for example.

The at least one absorber element may be, for example, at least one monolithic ceramic body, which has channels for the passage of hot gases and withdraws heat and has a pressure-reducing effect on introduced gas, so that the gas guided through this at least one absorber element is cooled and reduced in pressure further in addition to the cooling effect and/or pressure reduction caused by the at least one outflow path. For example, this module for receiving at least one absorber element may represent the module disclosed in German Patent Specification DE 103 13 723 B3, and the at least one absorber element disclosed in this patent specification may be used, however, any other suitable module for receiving at least one absorber element for damping and absorbing hot gases may also be used.

The positioning possibilities of the module 130 for receiving at least one absorber element schematically illustrated in Figures 3 and 4 only represent exemplary positioning possibilities, the at least one module 130 for receiving at least one absorber element may be located at any position inside at least one of the at least one outflow paths, for example, it may also be placed directly in front of at least one of the at least one outflow paths 101, 101' or behind the at least one outlet 105 of the at least one outflow path 101, 101'.

As shown as an example in the third and fourth embodiments in Figures 3 and 4, at least one of the at least one outflow paths 101, 101' may optionally have at least one additional opening 140 sealable using a closure element 150, the closure element 150 sealing the additional opening 140 in the event a predetermined pressure-dependent threshold is exceeded.

For example, the closure element 150 may be open in the normal operation of the electrical functional unit 110, i.e., when there is no malfunction generating a hot gas, so that waste heat generated during the normal operation in the electrical functional unit 110 may be discharged by the heated air through the exit opening 115 and the at least one open opening 140 directly to the environment, by which a heat buildup may be avoided, for example.

For example, if the pressure in the electrical functional unit 110 rises above a predetermined threshold, for example, in the event of a malfunction in the electrical functional unit 110, which may be an electric arc at a power switch, for example, the at least one additional opening 140 is closed by the particular closure element 150, and the hot gases are exhausted along the at least one outflow path 101, 101' to the at least one outlet 105 of the at least one outflow path 101, 101' to the environment and reduced in pressure and/or cooled at the same time, so that endangerment of individuals may be prevented. At least one module 130 for receiving at least one absorber element may optionally also be located in at least one of the at least one outflow paths 101, 101', as shown as an example in Figures 3 and 4.

The closure element 150 may, for example, represent at least one pivotably mounted flap 150, as shown as an example in Figures 3 and 4, the at least one additional opening 140 being able to be located on the top side of the at least one outflow path 101, 101' and the at least one flap 150 being situated hanging on the bottom side of the at least one opening 140, so that in the event of high pressure in the at least one outflow path, which may be generated, for example, by exiting hot gases in the event of a malfunction in the electrical functional unit 110, i.e., if a predetermined pressure-dependent threshold is exceeded, the at least one flap 150 closes automatically and thus closes the at least one additional opening 140. The at least one closure element 150 may also be implemented by other alternative embodiments, however, such as a valve, a configuration similar to a valve, or the like.

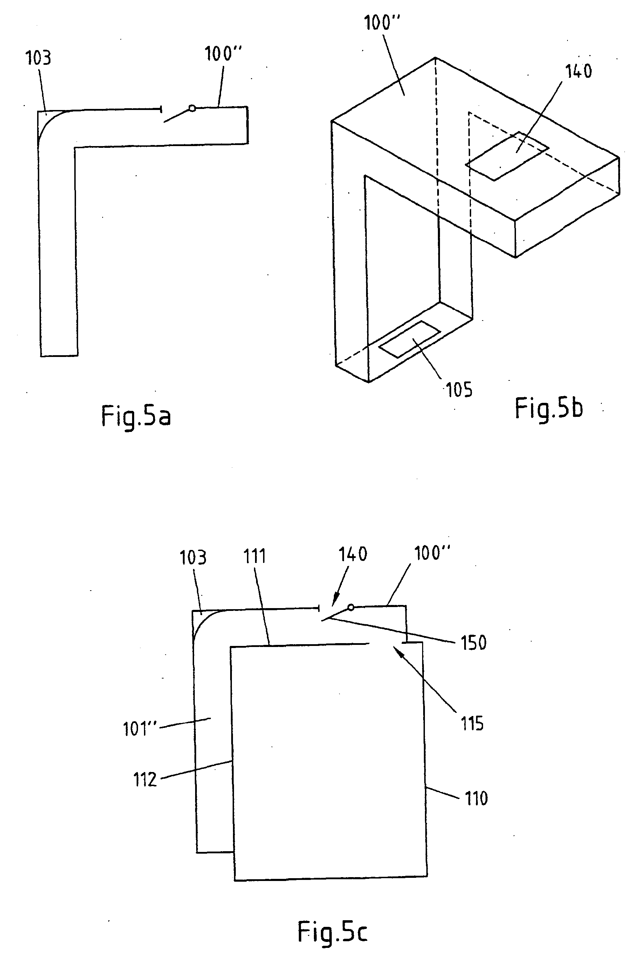

A fifth exemplary embodiment of the device 100" for ventilating an electrical functional unit 110 is schematically illustrated in Figures 5a, 5b, and 5c, this device 100" being implemented in the fifth embodiment in such a way that it forms a module 100" attachable to the electrical functional unit 110, which implements at least one outflow path 101" together with at least one exterior wall 111, 112 of the electrical functional unit 110.

The device 100, 100' shown in Figures 1-4 may also be implemented in such a way that it forms an attachable module 100, 100', which implements at least one outflow path 101, 101' together with at least one external wall 111, 112 of the electrical functional unit 110 (not shown in Figures 1-4).

Figure 5a shows a side view of the device 100", Figure 5b shows a diagonal view of the device 100", and attachable device 100" is attached to the electrical functional unit 110 in Figure 5c, so that the attached device 100" implements at least one outflow path 101" together with the top side 111 and the back side 112 of the electrical functional unit.

In Figures 5a-5c, the attachable module 100" is L-shaped, for example, so that the attachable module 100" may be pushed against the electrical functional unit 110 and fastened like a cassette, e.g., by a screw connection or other fasteners, and thus at least one outflow path 101 is implemented. The electrical functional unit 110 may have a box shape, for example. However, other shapes may also be used for the attachable module 100". The L-shaped module 100" comprises two oblong U-profiles, the particular open side of the U-profile of the attachable module 100" being closed in the attached state by the top side 111 and the back side 112 of the electrical functional unit 110 and the at least one outflow path 101" being implemented.

The at least one outflow path 101" has a curvature and/or a bend, this curvature being optimized for flow by an arc 103. This arc 103 is not shown in Figure 5b.

The attachable module 100" may be shaped from sheet metal, for example, the at least one outflow path 101 representing a sheet-metal duct. For example, lateral faces of a switching room wall of the electrical functional unit 110 may also be used to implement at least one outflow path.

Furthermore, the explanations and advantages cited for the first four embodiments apply equally for the fifth embodiment of the device 100" for ventilating an electrical functional unit 110 illustrated in Figures 5a-5c. Thus, for example, at least one module for receiving absorber elements for absorbing and damping hot gases may be placed in at least one of the at least one outflow paths 101", for example, and the device 100" may have at least one additional opening 140 closable using a closure element 150.

For all five embodiments described, the advantage is displayed that these devices 100, 100', 100" for ventilating an electrical functional unit 110 may be used for retrofitting electrical functional units, for example.

## Claims

1. An assembly including a device (100, 100', 100") for ventilating an electrical functional unit (110) of high and moderate voltage, and including the electrical functional unit the device (100, 100', 100") implementing at least one outflow path (101, 101', 101") located outside the electrical functional unit (110), which is impinged by exiting gases, and which has a pressure-reducing and/or cooling effect on the exiting gases of the electrical functional unit (110), and at least one of the at least one outflow paths (101, 101', 101") having at least one inlet opening, which is connectable to at least one exit opening (115) **characterized in that** said at least one exit opening (115) is located in an upper area of the electrical functional unit to receive exiting gases, and **in that** at least one of the at least one outflow paths (101, 101', 101") is running on the top side of the electrical functional unit (110) then having a bend and/or a curvature and is guided downward along a back side (112) of the electrical functional unit (110) and comprises an outlet (105) in a lower area.

2. The assembly according to claim 1, **characterized in that** at least one of the at least one outflow paths (101, 101', 101") is at least partially guided along at least one exterior side of the electrical functional unit.

3. The assembly according to one of claims 1 or 2, **characterized in that** at least one of the at least one outflow paths (101, 101', 101") has at least one curvature.

4. The assembly according to claim 1, **characterized in that** at least one of the at least one outflow paths (101, 101', 101") comprises a module (130) for receiving at least one absorber element for absorbing or damping hot gases.

5. The assembly according to claim 4, **characterized in that** at least one absorber element is at least one ceramic monolith having channels for the passage of gases.

6. The assembly according to one of the preceding claims, **characterized in that** at least one of the at least one outflow paths (101, 101', 101") has at least one additional opening (140) sealable using a closure element (150), the closure element (150) sealing the additional opening (140) if a predetermined pressure-dependent threshold is exceeded.

7. The assembly according to claim 6, **characterized in that** the closure element (150) represents a pivotably mounted flap (150).

8. The assembly according to one of the preceding claims, **characterized in that** the device represents a module (100") attachable to the electrical functional unit (110).

9. The assembly according to claim 8, **characterized in that** the attachable module (100") forms at least one of the at least one outflow paths (101, 101', 101") together with at least one exterior wall (111, 112) of the electrical functional unit (110).

10. The assembly according to claim 9, **characterized in that** the attachable module (100") is L-shaped and, in the attached state, forms at least one of the at least one outflow paths (101, 101', 101") with at least a part of the back side (112) and at least a part of the top side (111) of the electrical functional unit (110), the gases exiting from the electrical functional unit (110) being guided through at least one opening (115) on the top side (111) of the electrical functional unit (110) in the at least one of the at least one outflow paths and being conducted to the back side (112) of the electrical functional unit (110).

11. The assembly according to one of the preceding claims, **characterized in that** the electrical functional unit (110) represents a switchgear for moderate voltage and/or high voltage.

12. The assembly according to claim 11, **characterized in that** the switchgear is air-insulated.

13. The assembly according to claim 11, **characterized in that** the switchgear is gas-insulated.

14. The assembly according to one of claims 1 through 11, **characterized in that** the electrical functional unit (110) represents a transformer unit.

15. The assembly according to claim 11, **characterized in that** the switchgear is solid-insulated.

16. The assembly according to claim 11, **characterized in that** the switchgear is insulated by a liquid.

## Patentansprüche

1. Baugruppe, die eine Vorrichtung (100, 100', 100") zum Lüften einer elektrischen Funktionseinheit (110) von hoher und mittlerer Spannung enthält und die elektrische Funktionseinheit enthält, wobei die Vorrichtung (100, 100', 100") mindestens einen Ausströmpfad (101, 101', 101") implementiert, der außerhalb der elektrischen Funktionseinheit (110) angeordnet ist, auf den austretende Gase auftreffen, und der eine druckmindernde und/oder kühlende Wirkung auf die austretenden Gase der elektrischen Funktionseinheit (110) ausübt, und wobei mindestens einer der mindestens einen Ausströmpfade (101, 101', 101") mindestens eine Einlassöffnung aufweist, die mit mindestens einer Austrittsöffnung (115) verbunden werden kann, **dadurch gekennzeichnet, dass** die mindestens eine Austrittsöffnung (115) in einem oberen Bereich der elektrischen Funktionseinheit angeordnet ist, um austretende Gase zu empfangen, und dadurch, dass mindestens einer der mindestens einen Ausströmpfade (101, 101', 101") auf der Oberseite der elektrischen Funktionseinheit (110) verläuft, dann eine Biegung und/oder eine Krümmung vollführt und nach unten entlang einer Rückseite (112) der elektrischen Funktionseinheit (110) geführt wird und einen Auslass (105) in einem unteren Bereich umfasst.

2. Baugruppe nach Anspruch 1, **dadurch gekennzeichnet, dass** mindestens einer der mindestens einen Ausströmpfade (101, 101', 101") mindestens teilweise entlang mindestens einer Außenseite der elektrischen Funktionseinheit geführt wird.

3. Baugruppe nach einem der Ansprüche 1 oder 2, **dadurch gekennzeichnet, dass** mindestens einer der mindestens einen Ausströmpfade (101, 101', 101") mindestens eine Krümmung aufweist.

4. Baugruppe nach Anspruch 1, **dadurch gekennzeichnet, dass** mindestens einer der mindestens einen Ausströmpfade (101, 101', 101") ein Modul (130) zum Aufnehmen mindestens eines Absorberelements zum Absorbieren oder Dämpfen heißer Gase umfasst.

5. Baugruppe nach Anspruch 4, **dadurch gekennzeichnet, dass** mindestens ein Absorberelement mindestens ein Keramikmonolith ist, der Kanäle für den Durchgang von Gasen aufweist.

6. Baugruppe nach einem der vorangehenden Ansprüche, **dadurch gekennzeichnet, dass** mindestens einer der mindestens einen Ausströmpfade (101, 101', 101") mindestens eine zusätzliche Öffnung (140) aufweist, die mittels eines Verschlusselements (150) abgedichtet werden kann, wobei das Verschlusselement (150) die zusätzliche Öffnung (140) abdichtet, wenn eine vorgegebene druckabhängige Schwelle überschritten wird.

7. Baugruppe nach Anspruch 6, **dadurch gekennzeichnet, dass** das Verschlusselement (150) eine schwenkbar montierte Klappe (150) darstellt.

8. Baugruppe nach einem der vorangehenden Ansprüche, **dadurch gekennzeichnet, dass** die Vorrichtung ein Modul (100") darstellt, das an der elektrischen Funktionseinheit (110) angebracht werden kann.

9. Baugruppe nach Anspruch 8, **dadurch gekennzeichnet, dass** das anbringbare Modul (100") mindestens einen der mindestens einen Ausströmpfade (101, 101', 101") zusammen mit mindestens einer Außenwand (111, 112) der elektrischen Funktionseinheit (110) bildet.

10. Baugruppe nach Anspruch 9, **dadurch gekennzeichnet, dass** das anbringbare Modul (100") L-förmig ist und, in dem angebrachten Zustand, mindestens einen der mindestens einen Ausströmpfade (101, 101', 101") mit mindestens einem Teil der Rückseite (112) und mindestens einem Teil der Oberseite (111) der elektrischen Funktionseinheit (110) bildet, wobei die aus der elektrischen Funktionseinheit (110) austretenden Gase durch mindestens eine Öffnung (115) auf der Oberseite (111) der elektrischen Funktionseinheit (110) in dem mindestens einen der mindestens einen Ausströmpfade geführt werden und zu der Rückseite (112) der elektrischen Funktionseinheit (110) geleitet werden.

11. Baugruppe nach einem der vorangehenden Ansprüche, **dadurch gekennzeichnet, dass** die elektrische Funktionseinheit (110) eine Schaltanlage für mittlere Spannung und/oder hohe Spannung darstellt.

12. Baugruppe nach Anspruch 11, **dadurch gekennzeichnet, dass** die Schaltanlage luftisoliert ist.

13. Baugruppe nach Anspruch 11, **dadurch gekennzeichnet, dass** die Schaltanlage gasisoliert ist.

14. Baugruppe nach einem der Ansprüche 1 bis 11, **dadurch gekennzeichnet, dass** die elektrische Funktionseinheit (110) eine Transformatoreinheit darstellt.

15. Baugruppe nach Anspruch 11, **dadurch gekennzeichnet, dass** die Schaltanlage massiv isoliert ist.

16. Baugruppe nach Anspruch 11, **dadurch gekennzeichnet, dass** die Schaltanlage durch eine Flüssigkeit isoliert ist.

## Revendications

1. Assemblage comprenant un dispositif (100, 100', 100") pour ventiler une unité fonctionnelle électrique (110) de haute tension et de tension modérée, et comprenant l'unité fonctionnelle électrique, le dispositif (100, 100', 100") mettant en oeuvre au moins une voie d'écoulement de sortie (101, 101', 101") située à l'extérieur de l'unité fonctionnelle électrique (110), sur laquelle empiètent les gaz de sortie, et ayant un effet de réduction de pression et/ou de refroidissement sur les gaz de sortie de l'unité fonctionnelle électrique (110), et au moins l'une de l'au moins une voie d'écoulement de sortie (101, 101', 101") ayant au moins une ouverture d'entrée qui peut être reliée à au moins une ouverture de sortie (115), **caractérisé en ce que** ladite au moins une ouverture de sortie (115) est située dans une zone supérieure de l'unité fonctionnelle électrique pour recevoir des gaz de sortie, et **en ce qu'**au moins l'une de l'au moins une voie d'écoulement de sortie (101, 101', 101") passe sur le côté supérieur de l'unité fonctionnelle électrique (110), puis a une courbe et/ou une courbure et est guidée vers le bas le long d'un côté arrière (112) de l'unité fonctionnelle électrique (110) et comprend une sortie (105) dans une zone inférieure.

2. Assemblage selon la revendication 1, **caractérisé en ce qu'**au moins l'une de l'au moins une voie d'écoulement de sortie (101, 101', 101") est au moins partiellement guidée le long d'au moins un côté extérieur de l'unité fonctionnelle électrique.

3. Assemblage selon l'une des revendications 1 et 2, **caractérisé en ce qu'**au moins l'une de l'au moins une voie d'écoulement de sortie (101, 101', 101") a au moins une courbure.

4. Assemblage selon la revendication 1, **caractérisé en ce qu'**au moins l'une de l'au moins une voie d'écoulement de sortie (101, 101', 101") comprend un module (130) pour recevoir au moins un élément absorbeur pour absorber ou étouffer des gaz chauds.

5. Assemblage selon la revendication 4, **caractérisé en ce qu'**au moins un élément absorbeur est au moins un monolithe céramique ayant des voies pour le passage de gaz.

6. Assemblage selon l'une des revendications précédentes, **caractérisé en ce qu'**au moins l'une de l'au moins une voie d'écoulement de sortie (101, 101', 101") a au moins une ouverture supplémentaire (140) pouvant être scellée en utilisant un élément de fermeture (150), l'élément de fermeture (150) scellant l'ouverture supplémentaire (140) si un seuil prédéterminé dépendant de la pression est dépassé.

7. Assemblage selon la revendication 6, **caractérisé en ce que** l'élément de fermeture (150) représente un volet monté de manière à pouvoir pivoter (150).

8. Assemblage selon l'une des revendications précédentes, **caractérisé en ce que** le dispositif représente un module (100") pouvant être attaché à l'unité fonctionnelle électrique (110).

9. Assemblage selon la revendication 8, **caractérisé en ce que** le module attachable (100") forme au moins l'une de l'au moins une voie d'écoulement de sortie (101, 101', 101") avec au moins une paroi extérieure (111, 112) de l'unité fonctionnelle électrique (110).

10. Assemblage selon la revendication 9, **caractérisé en ce que** le module attachable (100") est en forme de L et, dans l'état attaché, forme au moins l'une de l'au moins une voie d'écoulement de sortie (101, 101', 101") avec au moins une partie du côté arrière (112) et au moins une partie du côté supérieur (111) de l'unité fonctionnelle électrique (110), les gaz sortant de l'unité fonctionnelle électrique (110) étant guidés à travers au moins une ouverture (115) sur le côté supérieur (111) de l'unité fonctionnelle électrique (110) dans au moins l'une de l'au moins une voie d'écoulement de sortie et étant conduits vers le côté arrière (112) de l'unité fonctionnelle électrique (110).

11. Assemblage selon l'une des revendications précédentes, **caractérisé en ce que** l'unité fonctionnelle électrique (110) représente un dispositif de commutation pour une tension modérée et/ou une haute tension.

12. Assemblage selon la revendication 11, **caractérisé en ce que** le dispositif de commutation est isolé de l'air.

13. Assemblage selon la revendication 11, **caractérisé en ce que** le dispositif de commutation est isolé des gaz.

14. Assemblage selon l'une des revendications 1 à 11, **caractérisé en ce que** l'unité fonctionnelle électrique (110) représente une unité de transformateur.

15. Assemblage selon la revendication 11, **caractérisé en ce que** le dispositif de commutation est isolé des solides.

16. Assemblage selon la revendication 11, **caractérisé en ce que** le dispositif de commutation est isolé par un liquide.
